# EUROPÄISCHE PATENTSCHRIFT

(11) **EP 1 794 817 B1**
(45) Veröffentlichungstag und Bekanntmachung des Hinweises auf die Patenterteilung: **15.08.2018**
(21) Anmeldenummer: 05802594.1
(22) Anmeldetag: 28.09.2005
(51) Int. Cl.: H01L 33/48, H01L 33/50

(54) **OPTOELEKTRONISCHES BAUELEMENT UND GEHÄUSE FÜR EIN OPTOELEKTRONISCHES BAUELEMENT**
OPTOELECTRONIC COMPONENT AND HOUSING FOR AN OPTOELECTRONIC COMPONENT
COMPOSANT OPTOELECTRONIQUE ET BOITIER POUR COMPOSANT OPTOELECTRONIQUE

(30) Priorität: 30.09.2004 DE 102004047640
(43) Veröffentlichungstag der Anmeldung: 13.06.2007
(73) Patentinhaber: OSRAM Opto Semiconductors GmbH, 93055 Regensburg (DE)
(72) Erfinder: HÄRLE, Volker, 93164 Laaber (DE)
(74) Vertreter: Epping - Hermann - Fischer
(86) Internationale Anmeldenummer: PCT/DE2005/001735
(87) Internationale Veröffentlichungsnummer: WO 2006/034703

(56) Entgegenhaltungen:
- EP-A- 0 809 304
- EP-A- 1 119 058
- EP-A- 1 187 226
- EP-A- 1 418 628
- WO-A-02/052615
- WO-A-02/056390
- US-A1- 2002 020 843
- US-A1- 2003 098 651
- US-A1- 2004 036 081
- US-A1- 2004 183 081
- US-A1- 2005 151 147
- PATENT ABSTRACTS OF JAPAN Bd. 2003, Nr. 12, 5. Dezember 2003 (2003-12-05) & JP 2003 243717 A (MATSUSHITA ELECTRIC WORKS LTD), 29. August 2003 (2003-08-29)
- PATENT ABSTRACTS OF JAPAN Bd. 2000, Nr. 15, 6. April 2001 (2001-04-06) & JP 2000 347601 A (TOSHIBA CO), 15. Dezember 2000 (2000-12-15)

## Beschreibung

Die Erfindung bezieht sich auf ein optoelektronisches Bauelement und auf ein Gehäuse für ein optoelektronisches Bauelement.

Oberflächenmontierbare (SMD) Leuchtdioden-Bauelemente (LEDs) in Leadframe-Technologie werden vielfach in einen am Leadframe vorgefertigten spritzgepressten oder spritzgegossenen Kunststoffgehäusekörper montiert, dort mit elektrischen Anschlussleitern verbunden und zum Schutz gegen schädigende äußere Einflüsse mit einer transparenten Vergussmasse verkapselt, durch die im Betrieb der LEDs Licht ausgekoppelt wird.

Insbesondere bei so genannten Konversions-LEDs, bei denen zumindest ein Teil der vom Halbleiterchip ausgesandten Strahlung (im Folgenden Primärstrahlung) von einem Leuchtstoff in der Vergussmasse in Strahlung mit gegenüber der Primärstrahlung zumindest teilweise veränderter Wellenlänge konvertiert wird, ist es technisch oftmals schwierig, die vorgesehene Menge an Leuchtstoff an der vorgesehenen Stelle einzubringen. Schwierigkeiten machen insbesondere eine Wellenlängenverteilung sowie eine Helligkeitsverteilung von nominell gleichartigen Halbleiterchips untereinander. Als technisches Problem sind unter anderem oftmals Segregationseffekte des Leuchtstoffes nach dem Aufbringen der Vergussmasse auf den Chip zu beobachten. Die oben genannten Aspekte können nicht unerheblich zu Ungleichmäßigkeiten in der Abstrahlcharakteristik von herkömmlichen Konversions-LEDs beitragen und die Ausbeute in der Massenfertigung beeinträchtigen.

Bekannte Konversions-LEDs sind beispielsweise in den Druckschriften WO 97/50132 A1, WO 98/12757 A1, WO 01/50540 A1, JP 2000 -347601 A, WO 02/052615 A2, JP 2003-243717 A, EP 1 119 058 A1, US 2002/0020843 A1 und EP 1 418 628 A1 beschrieben.

Eine Aufgabe der vorliegenden Erfindung besteht insbesondere darin, ein optoelektronisches Bauelement bereitzustellen, beim dem mit technisch möglichst einfachen Mitteln eine reproduzierbare Abstrahlcharakteristik in der Massenfertigung erzielbar ist.

Diese Aufgabe wird durch ein Gehäuse mit den Merkmalen des Patentanspruches 1 gelöst. Ein optoelektronisches Bauelement mit einem solchen Gehäuse ist in Patentanspruch 6 angegeben.

Vorteilhafte Ausführungsformen und Weiterbildungen des Gehäuses und des optoelektronischen Bauelements sind in den Unteransprüchen 2 bis 5 bzw. 7 und 8 angegeben. Bei einem optoelektronischen Bauelement gemäß der Erfindung ist ein Halbleiterchip und ein Lumineszenzkonversionsmaterial vorgesehen, der bzw. das geeignet ist, elektromagnetische Primärstrahlung zu emittieren bzw. zumindest einen Teil der Primärstrahlung zum absorbieren und Sekundärstrahlung mit gegenüber der Primärstrahlung zumindest teilweise geänderten Wellenlängen zu emittieren.

Weiterhin ist ein Gehäusegrundkörper vorgesehen, der eine Ausnehmung zur Aufnahme des Halbleiterchips und elektrische Anschlussleitungen zum externen elektrischen Anschließen des Halbleiterchips aufweist, die jeweils einerseits mit elektrischen Kontakten des Halbleiterchips elektrisch leitend verbunden sind und jeweils andererseits eine von außen kontaktierbare Anschlussfläche aufweisen.

Der Halbleiterchip ist in der Ausnehmung montiert und mit einem Chipverkapselungselement, das den Halbleiterchip gegenüber schädigenden Umwelteinflüssen schützen soll, umschlossen. Der Halbleiterchip ist beispielsweise mit Vorteil mittels einer Silikonharzmasse in die Ausnehmung montiert. Das Chipsverkapselungselement kann beispielsweise mit Vorteil eine Silikonharzmasse umfassen. Ebenso ist aber denkbar, dass das Chipverkapselungselement ein Material auf Basis von Epoxidharz und/oder PMMA umfasst, um beispielsweise einen verbesserten Schutz gegen mechanische Einflüsse zu erreichen. Ferner kann das Chipverkapselungselement ein Material auf Basis eines Epoxidharz-Silikonharz-Hybridmaterials umfassen mit zum Beispiel 50 Prozent Epoxidharzanteil und 50 Prozent Silikonharzanteil.

Der Gehäusegrundkörper ist zumindest für einen Teil der Primärstrahlung optisch durchlässig und eine optische Achse des Halbleiterchips verläuft durch den Gehäusegrundkörper, so dass ein Großteil der vom Halbleiterchip ausgesandten Primärstrahlung in den Gehäusegrundkörper eingestrahlt wird. Die optische Achse ist vorliegend die zentrale Achse eines vom Halbleiterchip ausgesandten Strahlungskegels. Der Begriff "optisch durchlässig" umfasst in breiter Bedeutung Transparenz, Transluzenz, Durchlässigkeit mit Dispersionsmitteln und andere Arten von optischer Durchlässigkeit.

Das Lumineszenzkonversionsmaterial ist in den Gehäusegrundkörper eingebettet und ist geeignet, zumindest einen Teil der Primärstrahlung in Sekundärstrahlung mit gegenüber der Primärstrahlung zumindest teilweise geänderten Wellenlängen zu konvertieren. Beispiele für geeignete Lumineszenzkonversionsmaterialien sind in den Druckschriften WO 97/50132 A1, WO 98/12757 A1 und WO 01/08452 A1 angegeben. Im Betrieb des Bauelements sendet der Gehäusegrundkörper elektromagnetische Strahlung aus, die durch den Gehäusegrundkörper hindurch tretende Primärstrahlung und vom Lumineszenzkonversionsmaterial emittierte Sekundärstrahlung umfasst.
Bei einer vorteilhaften Ausführungsform des Gehäusegrundkörpers umfasst dieser einen mittels eines Spritzgieß- oder Spritzpressverfahrens vorgefertigten Kunststoff-Formkörper.
Bei einer anderen vorteilhaften Ausführungsform umfasst der Gehäusegrundkörper einen vorgefertigten Formkörper aus Glas und/oder einer strahlungsdurchlässigen Keramik.
Mit Vorteil umfasst der Gehäusegrundkörper ein strahlformendes optisches Element und/oder ist selbst als strahlformendes optisches Element ausgebildet.
Der Gehäusegrundkörper weist eine von der Ausnehmung entfernt liegende äußere Schicht und eine die Ausnehmung umfassende innere Schicht auf, zwischen denen sich eine Konverterschicht befindet, die das Lumineszenzkonversionsmaterial enthält.

Die Dicke und/oder die Form der Konverterschicht kann hierbei mit Vorteil entsprechend einer über einen Abstrahl-Raumwinkel ungleichmäßigen Abstrahlcharakteristik des Halbleiterchips angepasst ausgebildet sein.

Besonders geeignet ist eine Bauform gemäß der Erfindung für Bauelemente, bei denen die Primärstrahlung ultraviolette Strahlung und/oder kurzwellige blaue Strahlung umfasst.

Bei einer bevorzugten Ausgestaltung des Bauelements ist der Gehäusegrundkörper an elektrische Anschlussleitungen eines metallischen elektrischen Leiterrahmens angeformt, die mit elektrischen Kontaktflächen des Halbleiterchips beispielsweise mittels Bonddrähten verbunden sind.

Bei einem Bauelement und einem Gehäuse gemäß der Erfindung wird der vorgefertigte Gehäusegrundkörper zur Lichtauskopplung verwendet und nicht, wie herkömmlich, eine klar vergossene Ausnehmung eines vorgefertigten Gehäusegrundkörpers. Hierzu ist der vorgefertigte Gehäusegrundkörper aus einer optisch durchlässigen Masse gefertigt. In diese Masse kann unter anderem Lumineszenzkonversionsmaterial in definierter Menge und Form eingebracht werden.

Der Halbleiterchip, der in einer derartigen Bauform in den Gehäusegrundkörper abstrahlt, ist in die Ausnehmung des Gehäusegrundkörpers eingesetzt und dort befestigt. Bei Halbleiterchips, die einen elektrischen Kontakt auf der dem Gehäusegrundkörper zugewandten Seite aufweisen, erfolgt dies mit Vorteil beispielsweise durch Verwendung eines transparenten leitfähigen Klebers. Bei Halbleiterchips, welche beide Kontakte auf der vom Gehäusegrundkörper abgewandten Seite aufweisen (z.B. Halbleiterchips auf Basis eines Nitrid-III/V-Verbindungshalbleitermaterials mit transparentem Substrat, beispielsweise Saphir-Substrat), kann die Befestigung des Halbleiterchips beispielsweise mittels einer Silikonharzmasse erfolgen.

Der Vorteil einer Silikonharzmasse besteht insbesondere in deren Stabilität gegenüber UV- und/oder kurzwelliger blauer Strahlung. In der Ausnehmung ist der Halbleiterchip von dessen Rückseite her mit einer Masse umschlossen, die hinsichtlich Widerstandsfähigkeit gegen schädigende Umwelteinflüsse optimiert werden kann und deren optischen Eigenschaften ohne Bedeutung sind.

Ein besonderer Vorteil des Bauelements besteht darin, dass der Gehäusegrundkörper inklusive Lumineszenzkonversionsmaterial auf technisch vergleichsweise einfache Weise an eine jeweils gegebene Chipcharakteristik angepasst werden kann. Es besteht die Möglichkeit, das Lumineszenzkonversionsmaterial in definierter Form, Menge und Dicke im Gehäusegrundkörper vorab zu integrieren, bevor der Halbleiterchip eingebaut wird. Nach Einbringen des Halbleiterchips stehen die optischen Eigenschaften des künftigen Bauelements bereits fest, so dass der Halbleiterchip nur noch elektrisch mit den elektrischen Anschlussleitern verbunden werden muss.

Die Ablagegenauigkeit eines Halbleiterchips mit einer aktuell in der Massenfertigung verfügbaren Montagetechnologie liegt abhängig von der Verbauungsgeschwindigkeit in der Größenordnung von 40-70µm bis herab zu 5µm. Diese Ablagegenauigkeit kombiniert mit einer vorgefertigten Optik des vorgefertigten Gehäusegrundkörpers ermöglichen vorteilhafterweise sehr exakt definierte Abstrahlcharakteristiken von LED-Bauelementen.
Ein weiterer bedeutender Vorteil liegt darin, dass das Gehäusekonzept gemäß der Erfindung die Möglichkeit der Kombination von strahlungsresistenten Materialien, wie z. B. Glas, mit kurzwelligen Emittern, sprich ultraviolette und/oder kurzwellige blaue Strahlung emittierende Halbleiterchips eröffnet.
Weitere Vorteile, vorteilhafte Ausführungsformen und Weiterbildungen der Erfindung ergeben sich aus den im Folgenden in Verbindung mit den Figuren 1 bis 4 beschriebenen Ausführungsbeispielen.

Es zeigen:
Figur 1, eine schematische Schnittdarstellung eines ersten erfindungsgemäßen Ausführungsbeispiels,
Figur 2, eine schematische Schnittdarstellung eines zweiten erfindungsgemäßen Ausführungsbeispiels,
Figur 3, eine schematische Schnittdarstellung eines nicht erfindungsgemäßen Beispiels, und
Figur 4, eine schematische Schnittdarstellung eines nicht erfindungsgemäßen Beispiels.

In den erfindungsgemäßen Ausführungsbeispielen und nicht erfindungsgemäßen Beispielen und zugehörigen Figuren sind gleiche oder gleich wirkende Bestandteile jeweils mit den gleichen Bezugszeichen versehen. Die dargestellten Elemente der Figuren, insbesondere die Schichtdicken, sind nicht als maßstabsgerecht anzusehen. Vielmehr können sie zum besseren Verständnis teilweise übertrieben groß dargestellt sein.

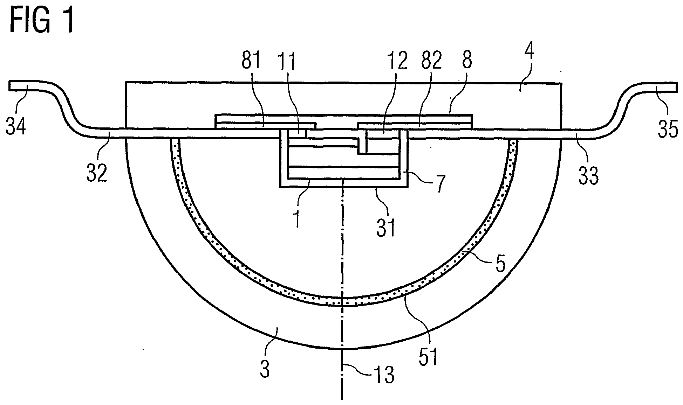

Bei dem erfindungsgemäßen Ausführungsbeispiel gemäß Figur 1 ist ein kalottenartig geformter Gehäusegrundkörper 3 mit einer Ausnehmung 31 an der von der kalottenartig gekrümmten Oberfläche abgewandten Seite des Gehäusegrundkörpers 3. In den Gehäusegrundkörper 3 ist Lumineszenzkonversionsmaterial 5 in Form einer Konverterschicht 51 eingebettet, die parallel zur kalottenartig gekrümmten Oberfläche verläuft. Das heißt, die Konverterschicht (51) weist zum Beispiel die gleiche oder im Wesentlichen die gleiche Krümmung wie die kalottenartig gekrümmte Oberfläche auf. Der Gehäusegrundkörper 3 wirkt aufgrund seiner kalottenartigen Form als strahlbündelnde Auskoppeloptik.
Der Gehäusegrundkörper 3 besteht beispielsweise aus einem spritzgegossenen oder spritzgepressten vorgefertigten Formkörper aus einem transparenten Kunststoffmaterial, aus Glas oder aus einem transparenten Keramikmaterial.
Der Gehäusegrundkörper 3 weist eine von der Ausnehmung 31 entfernt liegende äußere Schicht und eine die Ausnehmung umfassende innere Schicht auf, zwischen denen sich die Konverterschicht 51 befindet, die das Lumineszenzkonversionsmaterial 5 aufweist. Die innere und die äußere Schicht sind dabei frei von einem Lumineszenzkonversionsmaterial.

Beispiele für geeignete Lumineszenzkonversionsmaterialien sind in den Druckschriften WO 97/50132 A1, WO 98/12757 A1 und WO 01/08452 A1 angegeben und werden von daher an dieser Stelle nicht näher erläutert.
Die Ausnehmung 31 ist nur geringfügig größer dimensioniert als der strahlungsemittierende Halbleiterchip 1. Beispielsweise ist die Ausnehmung 31 höchstens 10 Prozent größer dimensioniert als der strahlungsemittierende Halbleiterchip 1. Bevorzugt ist die Ausnehmung 31 höchstens 7 Prozent größer dimensioniert als der strahlungsemittierende Halbleiterchip 1. Besonders bevorzugt ist die Ausnehmung 31 höchstens 2,5 Prozent größer dimensioniert als der strahlungsemittierende Halbleiterchip 1. Beispielsweise basiert der strahlungsemittierende Halbleiterchip 1 auf einem Nitrid-III/V-Verbindungshalbleitermaterial und sendet im Betrieb unter anderem ultraviolette und kurzwellige blaue Strahlung aus. Beispielsweise sind bei dem strahlungsemittierenden Halbleiterchip 1 die elektrische Anschlussfläche der p-Seite und die elektrische Anschlussfläche der n-Seite auf dessen von dem Gehäusegrundkörper 3 abgewandten Rückseite angeordnet. Solche Halbleiterchips 1 sind dem Fachmann bekannt und werden von daher an dieser Stelle nicht näher erläutert. Solche Halbleiterchips sind beispielsweise in den Druckschriften EP 599224 A1 und EP 622 858 A2 beschrieben. Der Halbleiterchip 1 ist mittels einer Verbindungsschicht 7 aus transparentem Silikonharz derart in der Ausnehmung 31 befestigt, dass dieser Strahlung in erster Linie in den Gehäusegrundkörper 3 hinein emittiert. Die optische Achse 13 des Halbleiterchips 1 verläuft durch den Gehäusegrundkörper 3.

An der Rückseite des Gehäusegrundkörpers 3 verlaufen von Außerhalb des Gehäusegrundkörpers 3 zur Ausnehmung 31 hin elektrische Anschlussleitungen 32,33, mit denen elektrische Kontakte 11,12 des Halbleiterchips 1 elektrisch leitend verbunden sind. Dies kann beispielsweise, wie in Figur 1 dargestellt, mittels eines Trägerplättchens 8 aus Halbleitermaterial erfolgen, das zwischen einer p-Kontaktfläche des Halbleiterchips 1 und der diesem zugeordneten Anschlussleitung 32 einen p-leitend dotierten Bereich 81 und zwischen einer n-Kontaktfläche des Halbleiterchips 1 und der diesem zugeordneten Anschlussleitung 33 einen n-leitend dotierten Bereich 82 aufweist. Die elektrisch leitenden Verbindungen zwischen den Kontaktflächen des Halbleiterchips 1 und den zugeordneten dotierten Bereichen 81,82 Trägerplättchens 8 können zum Beispiel mittels ITO- und/oder elektrisch leitenden ZnO-Schichten hergestellt sein. Auch Schichten aus anderen TCO (transparent conductive oxide) Materialien sind denkbar.

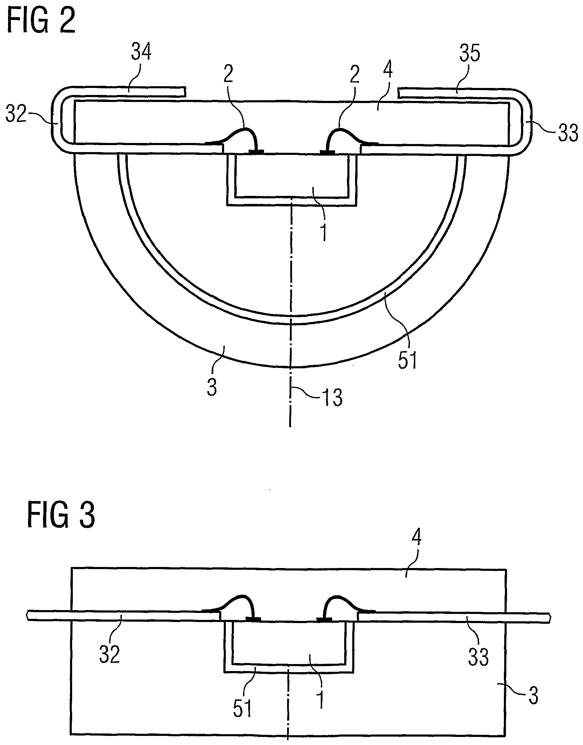

Alternativ können die elektrischen Verbindungen zwischen den Kontaktflächen des Halbleiterchips 1 und den Anschlussleitungen 32,33 beispielsweise mittels Bonddrähten 2 (vgl. Figur 2) oder mittels Metallfolien oder mittels geeigneter anderweitiger Mittel realisiert werden.

Die elektrischen Anschlussleitungen 32, 33 zum elektrischen Anschließen des Halbleiterchips 1 sind selbsttragende metallische Blechstreifen, die jeweils einerseits mit den elektrischen Kontakten 11,12 des Halbleiterchips 1 elektrisch leitend verbunden und jeweils andererseits eine von außen kontaktierbare Anschlussfläche 34,35 aufweisen. Sie sind außerhalb des Gehäusegrundkörpers derart geformt, beispielsweise schwingenartig, dass das Bauelement oberflächenmontierbar ist.
Bei Verwendung eines Halbleiterchips 1, bei dem sich die elektrischen Anschlussflächen der n-Seite und der p-Seite auf einander gegenüberliegenden Hauptflächen des Halbleiterchips 1 befinden, ist beispielsweise in der Ausnehmung eine elektrische Anschlussbahn, eine zum Beispiel metallische Leiterbahn angeordnet, um die zum Gehäusegrundkörper 3 hin gewandte Anschlussfläche mit einem der Anschlussleiter 32,33 zu verbinden.
Auf der Rückseite des Gehäusegrundkörpers 3 befindet sich eine den Halbleiterchip 1 einschließlich Trägerplättchen 8 verkapselnde Kunststoffmasse 4, deren Material beispielsweise auf Epoxidharz oder auf PMMA basieren und strahlungsabsorbierend und/oder reflektierend ausgebildet sein kann.

Das nicht erfindungsgemäße Beispiel gemäß Figur 3 unterscheidet sich von den vorangehend beschriebenen erfindungsgemäßen Ausführungsbeispielen insbesondere dadurch, dass das Lumineszenzkonversionsmaterial 5 nicht in den Gehäusegrundkörper 3 eingebettet ist, sondern in einer Konverterschicht 51 zwischen dem Halbleiterchip 1 und dem Formkörper des Gehäusegrundkörpers 3 in der Ausnehmung 31 enthalten ist. Diese Konverterschicht kann beispielsweise eine Matrix auf Silikonharzbasis umfassen, in die das Lumineszenzkonversionsmaterial 5 eingebettet ist. Ebenso ist aber auch eine Matrix auf Basis von Glas oder einer strahlungsdurchlässigen Keramik einsetzbar.

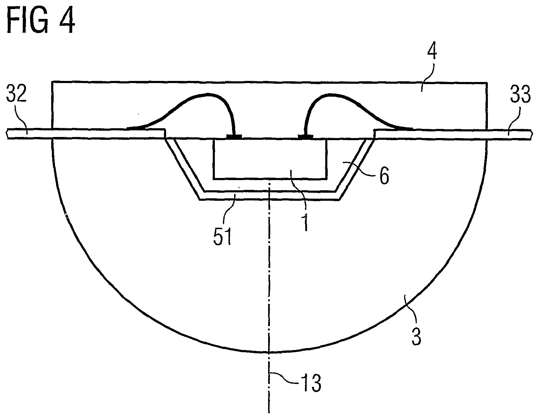

Alternativ können, wie in dem nicht erfindungsgemäßen Beispiel gemäß Figur 4 dargestellt, die Innenflächen der Ausnehmung 31 mit Lumineszenzkonversionsmaterial 5 beschichtet sein. Ein verbleibender Zwischenraum zwischen dem Halbleiterchip 1 und dem Lumineszenzkonversionsmaterial 5 ist dann vorzugsweise mit einer transparenten Füllmasse, wie z. B. Silikonharz, gefüllt.
Bei allen Ausführungsbeispielen kann auf technisch vergleichsweise einfache Weise die Dicke und/oder die Form der Konverterschicht 51 entsprechend einer über einen Abstrahl-Raumwinkel ungleichmäßigen Abstrahlcharakteristik des Halbleiterchips 1 angepasst ausgebildet werden.
Die Erfindung ist selbstverständlich nicht auf die explizit beschriebenen Ausführungsbeispiele eingeschränkt.

## Patentansprüche

1. Gehäuse für einen optoelektronischen Halbleiterchip (1), der geeignet ist, elektromagnetische Primärstrahlung zu emittieren, mit einem Gehäusegrundkörper (3), der eine Ausnehmung (31) zur Aufnahme des Halbleiterchips und einen Leiterrahmen mit elektrischen Anschlussleitungen (32, 33) zum elektrischen Anschließen des Halbleiterchips aufweist, der zumindest für einen Teil der Primärstrahlung zumindest teilweise durchlässig ist und in den ein Lumineszenzkonversionsmaterial (5) eingebettet ist, das geeignet ist, zumindest einen Teil der Primärstrahlung in Sekundärstrahlung mit gegenüber der Primärstrahlung zumindest teilweise geänderten Wellenlängen zu konvertieren,
**dadurch gekennzeichnet, dass**
der Gehäusegrundkörper eine von der Ausnehmung entfernt liegende äußere Schicht und eine die Ausnehmung umfassende innere Schicht aufweist, zwischen denen sich eine KonverterSchicht (51)
befindet, die das Lumineszenzkonversionsmaterial (5) aufweist, wobei die äußere und die innere Schicht frei von einem Lumineszenzkonversionsmaterial sind.

2. Gehäuse nach Anspruch 1, bei dem der Gehäusegrundkörper (3) einen mittels eines Spritzgieß- oder Spritzpressverfahrens vorgefertigten Kunststoff-Formkörper umfasst.

3. Gehäuse nach Anspruch 1, bei dem der Kunststoff-Formkörper an einen metallischen elektrischen Leiterrahmen angeformt ist.

4. Gehäuse nach Anspruch 1, bei dem der Gehäusegrundkörper (3) einen vorgefertigten Formkörper aus Glas oder strahlungsdurchlässiger Keramik umfasst.

5. Gehäuse nach mindestens einem der Ansprüche 1 bis 4, bei dem der Gehäusegrundkörper (3) ein strahlformendes optisches Element umfasst.

6. Optoelektronisches Bauelement mit einem Halbleiterchip (1), der geeignet ist, elektromagnetische Primärstrahlung zu emittieren, und mit einem Gehäuse nach einem der Ansprüche 1 bis 5, wobei
- die elektrischen Anschlussleitungen (32, 33) jeweils einerseits mit elektrischen Kontakten (11,12) des Halbleiterchips (1) elektrisch leitend verbunden sind und jeweils andererseits eine von außen kontaktierbare Anschlussfläche (34,35) aufweisen,
- das optoelektronische Bauelement ein Chipverkapselungselement (4) aufweist, das den Halbleiterchip (1) in der Ausnehmung umschließt,
- eine optische Achse (13) des Halbleiterchips (1) durch den Gehäusegrundkörper (3) verläuft, so dass ein Großteil der vom Halbleiterchip (1) ausgesandten Primärstrahlung in den Gehäusegrundkörper (3) eingestrahlt wird, und
- der Gehäusegrundkörper (3) im Betrieb des Bauelements Mischstrahlung emittiert, die durch den Gehäusegrundkörper (3) hindurchtretende Primärstrahlung und vom Lumineszenzkonversionsmaterial (5) emittierte Sekundärstrahlung (6) umfasst.

7. Optoelektronisches Bauelement nach Anspruch 6, bei dem die Dicke und/oder die Form der Konverterschicht (51) an eine gegebene, über einen Abstrahl-Raumwinkel ungleichmäßige Abstrahlcharakteristik des Halbleiterchips (1) angepasst ausgebildet ist.

8. Optoelektronisches Bauelement nach Anspruch 6 oder 7, bei dem die Primärstrahlung ultraviolette Strahlung umfasst.

## Claims

1. Housing for an optoelectronic semiconductor chip (1), which is suitable to emit electromagnetic primary radiation, having a housing base body (3), which comprises a recess (31) for receiving the semiconductor chip and a lead frame having electrical connection leads (32, 33) for electrically connecting the semiconductor chip, said lead frame is at least partially permeable to at least part of the primary radiation and into which a luminescence conversion material (5) is embedded, which is suitable to convert at least a part of the primary radiation into secondary radiation with wavelengths which are at least partially changed relative to the primary radiation,
**characterized in that**
the housing base body has an outer layer remote from the recess and an inner layer comprising the recess, between which a converter layer (51) is arranged, which has the luminescence conversion material (5), wherein the outer layer and the inner layer are free of a luminescence conversion material.

2. Housing according to claim 1, in which the housing base body (3) comprises a prefabricated plastic molded body by means of an injection molding or transfer molding process.

3. Housing according to claim 1, in which the plastic molded body is formed on a metallic electrical lead frame.

4. Housing according to claim 1, in which the housing base body (3) comprises a prefabricated molded body of glass or radiation-transmissive ceramic.

5. Housing according to at least one of claims 1 to 4, in which the housing base body (3) comprises a beam-shaping optical element.

6. Optoelectronic component comprising a semiconductor chip (1), which is suitable for emitting electromagnetic primary radiation, and having a housing according to one of claims 1 to 5, wherein
- the electrical connection leads (32, 33), which on the one hand are respectively connected in an electrically conducting manner to electrical contacts (11,12) of the semiconductor chip (1) and on the other hand respectively have a connecting surface (34, 35), which is contactable from the outside,,
- the optoelectronic component has a chip encapsulation element (4), which encloses the semiconductor chip (1) in the recess,
- an optical axis (13) of the semiconductor chip (1) extends through the housing base body (3), so that a majority of the primary radiation emitted by the semiconductor chip (1) is irradiated into the housing base body (3), and
- the housing base body (3) emits mixed radiation during operation of the component, said mixed comprises primary radiation passing through the housing base body (3) and secondary radiation (6) emitted by the luminescence conversion material (5).

7. Optoelectronic component according to claim 6, in which the thickness and/or the shape of the converter layer (51) is adapted to a given emission characteristic of the semiconductor chip (1), which is non-uniform over a solid radiating angle.

8. Optoelectronic component according to claim 6 or 7, in which the primary radiation comprises ultraviolet radiation.

## Revendications

1. Boîtier pour puce une semi-conductrice optoélectronique (1) approprié pour émettre un rayonnement électromagnétique primaire, comprenant un corps de base du boîtier (3) présentant un évidement (31) pour recevoir la puce semi-conductrice et une grille de connexion avec des câbles de raccordement électrique (32, 33) afin de procéder au raccordement électrique de la puce semi-conductrice, qui est au moins partiellement perméable pour une partie du rayonnement primaire et dans laquelle est incorporé un matériau de conversion de luminescence (5) capable de convertir au moins une partie du rayonnement primaire en rayonnement secondaire avec des longueurs d'onde au moins partiellement modifiées par rapport au rayonnement primaire, **caractérisé en ce que**
le corps de base du boîtier présente une couche externe éloignée de l'évidement et une couche interne comprenant l'évidement, entre lesquelles se trouve une couche de convertisseur (51) comprenant le matériau de conversion de luminescence (5), la couche externe et la couche interne étant exemptes d'un matériau de conversion luminescent.

2. Boîtier selon la revendication 1, dans lequel le corps de base du boîtier (3) comprend une pièce moulée en plastique préfabriqué par moulage par injection ou moulage par transfert.

3. Boîtier selon la revendication 1, dans lequel la pièce moulée en plastique est moulée sur une grille de connexion métallique.

4. Boîtier selon la revendication 1, dans lequel le corps de base du boîtier (3) comprend une pièce moulée préfabriquée en verre ou en céramique perméable au rayonnement.

5. Boîtier selon au moins l'une des revendications 1 à 4, dans lequel le corps du boîtier (3) comprend un élément optique formant un faisceau.

6. Composant optoélectronique comprenant une puce semi-conductrice (1) capable d'émettre un rayonnement électromagnétique primaire et équipé d'un boîtier selon l'une des revendications 1 à 5, dans lequel
- les câbles de raccordement électrique (32, 33) sont chacun reliés électriquement à des contacts électriques (11, 12) de la puce semi-conductrice (1) d'une part et présentent une surface de connexion (34, 35) pouvant être contactée de l'extérieur d'autre part,
- le composant optoélectronique comprend un élément d'encapsulation de puce (4) entourant la puce semi-conductrice (1) dans l'évidement,
- un axe optique (13) de la puce semi-conductrice (1) s'étend à travers le corps de base du boîtier (3) de telle sorte qu'une grande partie du rayonnement primaire émis par la puce semi-conductrice (1) est transmise au corps de base du boîtier (1) et
- le corps de base du boîtier (3) émet un rayonnement mixte pendant le fonctionnement du composant, comprenant un rayonnement primaire traversant le corps de base du boîtier (3) et un rayonnement secondaire (6) émis par le matériau de conversion de luminescence (5).

7. Composant optoélectronique selon la revendication 6, dans lequel l'épaisseur et / ou la forme de la couche de conversion (51) est adaptée à une caractéristique de rayonnement donnée de la puce semi-conductrice (1) et irrégulière via un angle solide de rayonnement.

8. Composant optoélectronique selon la revendication 6 ou 7, dans lequel le rayonnement primaire comprend un rayonnement ultraviolet.
